# EUROPEAN PATENT APPLICATION

(11) **EP 0 690 479 A1**
(43) Date of publication of application: **03.01.1996**
(21) Application number: 95110167.4
(22) Date of filing: 29.06.1995
(51) Int. Cl.: H01L 21/00

(54) **Method and apparatus for processing substrates, and apparatus for transferring the substrates**

(30) Priority: 30.06.1994 JP 170460/94; 29.03.1995 JP 72146/95; 08.06.1995 JP 164526/95
(71) Applicant: SEIKO EPSON CORPORATION, Shinjuku-ku Tokyo 163 (JP)
(72) Inventor: Iwamura, Naoyuki, c/o Seiko Epson Corp., Suwa-shi, Nagano-ken, 392 (JP); Mori, Yoshiaki, c/o Seiko Epson Corp., Suwa-shi, Nagano-ken, 392 (JP); Miyashita, Takeshi, c/o Seiko Epson Corp., Suwa-shi, Nagano-ken, 392 (JP); Miyakawa, Takuya, c/o Seiko Epson Corp., Suwa-shi, Nagano-ken, 392 (JP); Yudasaka, Ichio, c/o Seiko Epson Corp., Suwa-shi, Nagano-ken, 392 (JP)
(74) Representative: Hoffmann, Eckart, Dipl.-Ing.

(57) **Abstract**

In order to rationalize the steps for processing or inspecting substrates and to improve the yield in manufacturing semiconductor devices or liquid crystal display panels, a unit for generating gas discharge in a predetermined discharge gas under the atmospheric pressure or a pressure near the atmospheric pressure is provided at a position in a passage through which the substrates are conveyed, the surface of the wafer is exposed to activation species/radicals of the discharge gas generated by the gas discharge generating unit and the type of the discharge gas is appropriately selected so that surface treatment for the wafer, such as ashing, washing and giving hydrophilic nature, is performed in an in-line manner.

## Description

The present invention relates to a method and an apparatus for use during manufacturing of semiconductor devices, for example, LSIs, or liquid crystal display panels. More particularly the invention relates to a method and apparatus capable of processing substrates such that conveying means, such as robot arms and conveyor belts, are used to automatically convey substrates so as to consecutively perform a variety of processes, such as a film forming process, an etching process or an ion implantation process, and/or a variety of inspections like inspection of thickness, electrical characteristics, appearance and the like.

The present invention relates further to an apparatus for transferring a plurality of substrates from one cassette to another cassette.

The term "substrate" as used in this text has a broad meaning covering particularly (semiconductor) wafers but also other types of substrate such as substrates (glass substrates and others) of LCD panels.

Generally, semiconductor devices or liquid crystal display panels have been manufactured in such a manner that a variety of processes have been performed, for example, a thin film is formed on the surface of a substrate by sputtering or the like, the photolithographic technique using a resist film is employed, heat treatment, and introduction of impurities are performed. As a process preceding or succeeding the foregoing processes, modification and degreasing of the surfaces of the substrates and washing, degreasing, or the like for removing metal and foreign matters adhering to the surface are performed. Furthermore, a variety of inspections of the appearance, dimensions, thickness, resistance value, other electric characteristics and the like of the substrates are performed during the manufacturing process or after the products have been manufactured, as the need may be. The productivity has been improved by placing and conveying between the foregoing processes or inspections, as one unit, a multiplicity of, for example, 10 to 25, substrates on one cassette. Recently, automating of each of the foregoing processes has been promoted, and a consecutive processing system for automatically conveying substrates and for consecutively performing the various processes has been developed, so that the manufacturing process has been rationalized and the productivity has been improved. The foregoing trend of automation results in decrease in the number of operators, who are the source of dust generation, so that the cleanliness of the environment of the manufacturing field is improved, and defects of products are prevented.

Specifically, when a thin film is formed by sputtering, a process has been generally employed in which, for example, a Ti + TiN film is formed, and then an asher is used to oxidize the TiN film with an oxygen plasma before an Al-Cu + TiN film is formed so as to improve the barrier characteristic. When a resist film is formed, introduction of an etching solution in a following wet etching process has been facilitated by processing the substrate with oxygen plasma by using the asher immediately before the resist is applied to the substrate so as to render the surface of the substrate hydrophilic. Similarly, the substrate is processed with oxygen plasma by using an asher immediately before a wet etching process is performed, so that the resist film became hydrophilic and thus introduction of the etching solution has been facilitated.

Although the dry etching process is usually performed by using a plasma generated in a vacuum, scum in the resist film is removed with oxygen plasma by using an asher before the dry etching process is performed; and surface treatment with CF₄, O₂ or the like is performed after the etching process has been performed as a corrosion prevention process. To completely remove the residual photoresist, a layer of the photoresist film damaged by the plasma due to the etching process is removed by oxygen plasma by using an asher; and a residual resist film is separated by a wet method using a chemical solution. The ashing process and the subsequent process for removing the resist film respectively use exclusive cassettes to prevent contamination of the substrate. Furthermore, a special apparatus is used to transfer a multiplicity of substrates from one cassette to another cassette so that a consecutive process is performed.

The substrates are washed by a wet washing process using sulfuric acid, an organic solvent, pure water, a scrubber or the like or by a dry washing process using ozone, UV irradiation, oxygen plasma or the like to meet the purpose of the substrates. By appropriately setting the position, at which the washing process is performed, the washing method and washing conditions, the surfaces of the substrates can satisfactorily be washed. Thus, the quality, thickness and contact with the base of the thin film formed on the substrate can be maintained. Furthermore, removal of foreign matters adhering to the surface of the substrate before or after the film has been formed will prevent generation of defects, and improve the yield, thus resulting in reduction in the manufacturing cost and an improvement in the reliability. In order to also prevent contamination of the substrate due to dust and/or foreign matters adhering to the cassette for conveying and accommodating the substrate, the cassette is periodically washed.

However, since the conventional asher generally generates plasma in a vacuum, a special facility, such as a vacuum chamber and a vacuum pump, is required. Thus, the overall size of the apparatus is large, its structure is complicated, and the apparatus becomes costly, thus resulting in that the manufacturing cost cannot be reduced. What is worse, a difficulty arises in integrating processing apparatuses for performing sputtering, forming the resist film and performing the etching process with the asher to automatically and consecutively perform the sequential processes. Thus, there arises a problem in that the rationalization of the manufacturing process and improvement in the manufacturing yield encounter limitations. For example, the dry etching process, as described above, requires an asher, an apparatus for removing the resist film, and an apparatus for transferring the substrate between the foregoing units in order to completely remove the photoresist. Furthermore, since the ashing, transference of the substrates and removal of the resist are performed individually, the processing operations are too complicated and an excessively long time is required. Moreover, since all of the foregoing processes are performed in a clean room exhibiting excellent cleanliness to prevent contamination of the substrates, the clean room must have a wide space.

The automation of the manufacturing process has resulted in that a multiplicity of conveying mechanisms, such as robot arms, conveyor belts and carriers, have been used. In the portions of the conveying mechanisms, that are brought into direct contact with the multiplicity of the substrates, which are sequentially conveyed, slight contamination of dust adhering to the substrates or the like remains and accumulates as the time passes. If the thus-contaminated conveying mechanisms are used, substrates, that have been previously cleaned in a washing process, can be contaminated again due to such residual contamination. Therefore, there arises a problem in that, for example, in a film forming process, the quality of the film deteriorates or the film becomes defective and, therefore, the yield deteriorates. Although the conventional technique causes the cassettes to be wet-washed as described above, the portions of the conveying mechanisms, such as the robot arms, that are brought into direct contact with the substrates have been subjected to a simple cleaning process, for example, such that operators wipe the contaminated portions down with dust preventive clothes or the like impregnated with an organic solvent. Thus, satisfactory cleanliness has not been realized.

Some apparatuses for processing substrates, that have been automated by integrating the conveying mechanisms, have such a complicated structure that does not allow the wiping down operation of the conveying mechanisms by using the dust preventive. In this case, it is effective to remove and wet-wash the portions of the conveying mechanisms that are brought into direct contact with the substrates. However, the operation of the processing apparatus must be stopped during the wet washing process. Thus, there arises a problem in that the throughput deteriorates excessively.

In view of the foregoing, an object of the present invention is to provide an apparatus for processing substrates, which is capable of consecutively performing a variety of processes for substrates, such as sputtering, forming of a resist film and wet and dry etching, and surface treatment, such as ashing, that is an accompanying pre- or post-process of the foregoing processes, without special facilities for realizing a vacuum state or reducing pressure and a clean room; which enables the overall body of the apparatus to be relatively simple and integrated with a low cost; and with which the manufacturing process can be rationalized, the cost can be reduced and the productivity can be improved.

Another object of the present invention is to provide a processing apparatus and a processing method for consecutively and automatically performing a variety of processes or inspections of substrates, which are capable of, in the field, washing the portions of a conveying mechanism, which are brought into direct contact with the substrates at the time of conveying the substrates, without a necessity of removing the conveying mechanism from the processing apparatus, with which contamination of the substrates can be prevented without deterioration in the throughput, and which is capable of improving the yield, reducing the cost and improving the productivity and the reliability.

Another object of the present invention is to provide an apparatus for transferring substrates which does not require any special facilities for realizing a vacuum state or reducing the pressure for performing surface treatment, such as ashing, when a multiplicity of substrates are transferred from one cassette to another cassette between different processing steps, with which the overall apparatus body can be simplified and its size can be reduced, spaces for a clean room and providing the apparatus can effectively be used, which can be manufactured with a low cost, which enables the process and operation to be simplified, with which the cost can be reduced and the processing time can be shortened to improve the productivity.

These and other objects are achieved with the present invention as defined in the claims.

According to the apparatus claimed in claim 1, the processes or the inspections for the substrates, the conveyance of the substrates and a preceding or succeeding process using a plasma generated by a gas discharge in the ambient atmosphere can be consecutively performed. Since no vacuum facility is required to perform the preceding or succeeding process, the process and the structure of the overall body of the apparatus can be simplified.

According to the apparatus claimed in claim 2, desired surface treatment on the substrates can be performed during conveyance of the substrates.

According to the apparatus claimed in claim 3, the gas discharge is caused to take place in the discharge gas containing oxygen so that oxygen activation species/oxygen radicals are generated. By exposing the surfaces of the substrates to the oxygen activation species/oxygen radicals, ashing or surface modification for giving hydrophilic nature to the surfaces of the substrates or the like can be performed.

According to the apparatus claimed in claim 4, a plurality of processes or inspections and their accompanying surface treatment can be performed consecutively. According to the apparatus claimed in claim 5, sputtering and its accompanying surface treatment of substrates and/or forming of resist films and its accompanying surface treatment of substrates and/or wet etching and its accompanying surface treatment of the substrates and/or dry etching and its accompanying surface treatment of the substrates can be performed consecutively.

According to the method claimed in claim 6, washing of the conveying mechanism by ashing can be performed in the field without deterioration in the throughput by exposing the conveying mechanism to oxygen activation species/oxygen radicals generated under the atmospheric pressure with processes or inspections of the substrates being performed consecutively without a necessity of removing the conveying mechanism or require of a vacuum facility. Therefore, readhesion of contamination from the conveying mechanism to the substrates can efficiently be prevented.

According to the method claimed in claim 7, the conveying mechanism can be washed between the first conveying process and the second conveying process in an empty state where the substrates are not placed on the conveying mechanism. Thus, the consecutive processes or inspections of the substrates need not be interrupted.

According to the apparatus claimed in claim 8, the washing means, that does not require any vacuum facility simplifies the overall structure of the apparatus. Thus, an in-line system with the means for processing or inspecting substrates can easily be established so that the processing method claimed in claim 9 is realized.

According to the apparatus claimed in claim 9, the conveying mechanism can be washed during a usual operation process for conveying substrates.

According to the apparatus claimed in claim 10, a plurality of processes or inspections are consecutively performed so that the conveying mechanism can be washed without deterioration in the throughput.

According to the apparatus claimed in claim 11, an apparatus for subjecting substrates to any of a variety of processes, such as sputtering and etching, or for inspecting the appearance or the electric characteristic of the same can be given a self-cleaning mechanism. Thus, a means, such as a stage or a table, for holding a substrate can be cleaned in a short time at room temperature and under the atmospheric pressure.

According to the apparatus claimed in claim 12, no vacuum apparatus or processing chamber for accommodating the substrates is required to perform an ashing process to be performed during conveyance of the substrates. Thus, the process and the overall body of the apparatus can be simplified, and the substrates, which are being conveyed at high speed, can be processed quickly.

According to the apparatus claimed in claim 13, disposition of the dielectric member between the grounded electrode and the substrate enables stable gas discharge without arc discharge to be obtained. By making the grounded electrode to have a size larger than that of the substrate and by making the dielectric member to have a size larger than the grounded electrode, the overall surface of the substrate can be exposed to the gas discharge without direct exposure of the grounded electrode to the gas discharge.

According to the apparatus claimed in claim 14, the dielectric member and the grounded electrode are used as the tables, on which the substrate is placed, so that the substrate is exposed to gas discharge so as to be ashed while being conveyed from the first cassette to the second cassette by the conveying means.

According to the apparatus claimed in claim 15, fixing of the dielectric member and the grounded electrode will enable gas discharge to always take place regardless of whether or not a substrate exists. Thus, the discharge state can be stabilized.

According to the apparatus claimed in claim 16, the substrate is not directly exposed to the gas discharge so that damage of the substrate can be prevented. By varying the size and the shape of the port for jetting out a gas flow including activation species/radicals, an ashing process adaptable to the dimensions and the shape of the substrate can be performed.

Other and further objects, features and advantages of the invention will be appear more fully from the following description.
- Fig. 1: is a diagram schematically showing the structure of a substrate transfer apparatus according to the present invention;
- Fig. 2: is a plan view showing the substrate transfer apparatus shown in Fig. 1;
- Fig. 3: is a cross sectional view showing the structure of an asher for use in the substrate transfer apparatus shown in Fig. 1;
- Fig. 4: is a cross sectional view showing another embodiment of the asher;
- Fig. 5: is a cross sectional view showing another embodiment of the asher;
- Fig. 6: is a side view similar to Fig. 1 and showing another embodiment of the substrate transfer apparatus;
- Fig. 7: is a plan view similar to Fig. 2 and showing another embodiment of the substrate transfer apparatus;
- Fig. 8: is a partial plan view schematically showing a conveying mechanism of an apparatus for processing substrates according to the present invention;
- Fig. 9: is a partially-enlarged side view of the conveying arm shown in Fig. 8;
- Fig. 10: is a partially-enlarged side view showing a state where the conveying arm shown in Fig. 8 is washed with atmospheric-pressure plasma by a method according to the present invention;
- Fig. 11: is a partially-enlarged view showing another embodiment of the conveying arm;
- Fig. 12: is a plan view schematically showing a sputtering apparatus according to the present invention;
- Fig. 13: (A) is a plan view schematically showing the structure of a resist film forming apparatus according to the present invention, and (B) is a front view;
- Fig. 14: (A) is a plan view schematically showing the structure of a wet etching apparatus according to the present invention, and (B) is a front view; and
- Fig. 15: is a plan view schematically showing the structure of a dry etching apparatus according to the present invention.

Preferred embodiments of the present invention will now be described in detail with reference to the drawings.

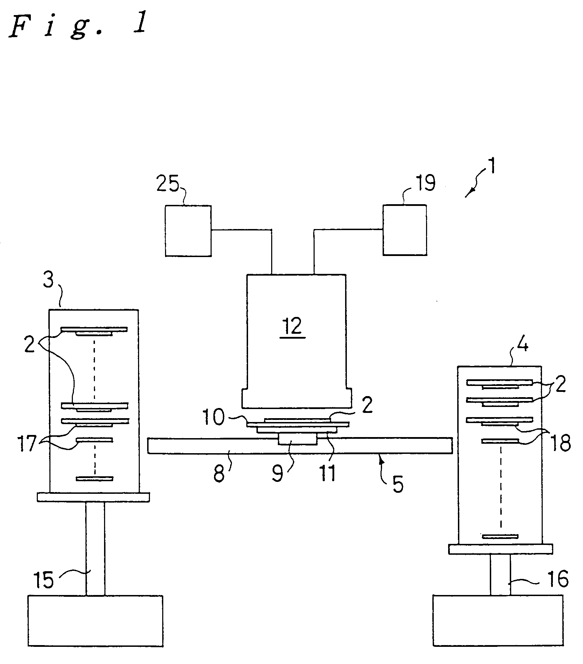

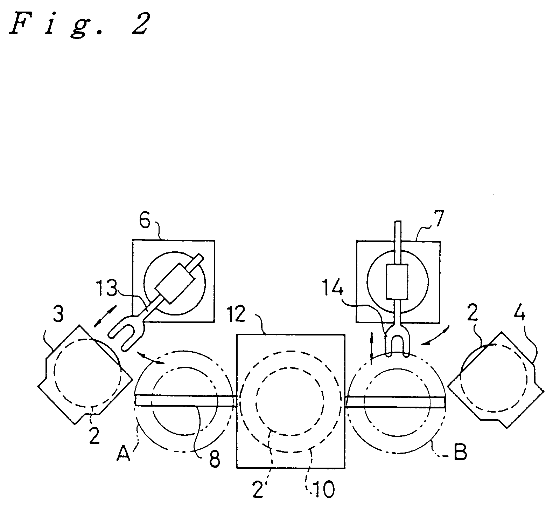

Figs. 1 and 2 schematically show a preferred embodiment of a substrate transfer apparatus according to the present invention. A substrate transfer apparatus 1 according to this embodiment transfers substrates, which have been subjected to, for example, dry etching, by a cassette-to-cassette method so as to introduce the substrates to a subsequent resist-film removal process. The substrate transfer apparatus 1 comprises, between a sender cassette 3 that accommodates a multiplicity of substrates (wafers) 2 and a receiver cassette 4, a conveyor means 5 for conveying the substrates 2, an unloader 6 for taking out the substrates 2 from the sender cassette 3 to place the substrates 2 on the conveyor means 5, and a loader 7 for transferring the substrates 2 from the conveyor means 5 to the receiver cassette 4.

The conveyor means 5 comprises guide rails 8 extending from the sender cassette 3 to the receiver cassette 4, and a slider 9 that moves on the guide rails 8 in the two opposing directions by drive means (not shown). A disc-like table 10 made of dielectric material and capable of receiving the substrates 2 thereon is secured to the upper surface of the slider 9 through a base 11 made of electrically conductive material that is grounded. The base 11 has a disc-like shape having a diameter that is larger than that of the substrate 2, while the table 10 has a diameter that is larger than that of the base 11. An asher 12 according to the present invention is disposed at an intermediate position between the two cassettes 3 and 4 above the guide rails 8.

The unloader 6 and the loader 7 have the same structure and comprise corresponding rotative arms 13 and 14 each of which is capable of extending/contracting back and forth. The sender cassette 3 and the receiver cassette 4 are disposed on corresponding lifting apparatuses 15 and 16 so that each of the two cassettes 3 and 4 can be moved upwards/downwards to a desired level. The two cassettes 3 and 4 include corresponding racks 17 and 18 so that the multiplicity of substrates 2 are, one by one, placed on the rack so as to be arranged vertically.

The sender cassette 3 filled with substrates 2 is, by the lifting apparatus 15, moved so that the lowermost substrate 2 in the sender cassette 3 is on the level of the rotative arm 13 of the unloader 6. On the other hand, the empty receiver cassette 4 is, by the lifting apparatus 16, moved so that the uppermost part of rack 18 is on the level of the rotative arm 14 of the loader 7. The unloader 6 causes the rotative arm 13 to extend into the sender cassette 3 so that the lowermost substrate 2 is placed in the leading portion of the rotative arm 13 and is taken out. Then, the unloader 6 rotates the rotative arm 13 toward the table 10 disposed at position A near the sender cassette 3 while again extending the rotative arm 13. Thus, the substrate 2 is placed on a predetermined position of the table 10. The table 10 is moved from the position A to position B near the receiver cassette 4 when the slider 9 is moved along the guide rails 8 by the drive means. The loader 7 causes the rotative arm 14 to extend toward the table 10 at the position B so that the substrate 2 is taken out and placed on the leading portion of the rotative arm 14, followed by being rotated so as to be accommodated in the rack 18 of the receiver cassette 4.

The table 10 is returned from the position B to the position A by the drive means. The sender cassette 3 is moved downwards by the lifting apparatus 15 so that the second substrate 2 from the lowermost position is on the level of the rotative arm 13 of the unloader 6. The receiver cassette 4 is moved upwards by the lifting apparatus 16 so that the second position of the rack 18 from the uppermost position is on the level of the rotative arm 14 of the loader 7. The second substrate 2 is taken out from the sender cassette 3, conveyed and loaded into the receiver cassette 4 in the same way as has been explained for the first substrate. By repeating this process, all substrates 2 in the sender cassette 3 are successively transferred to the receiver cassette 4.

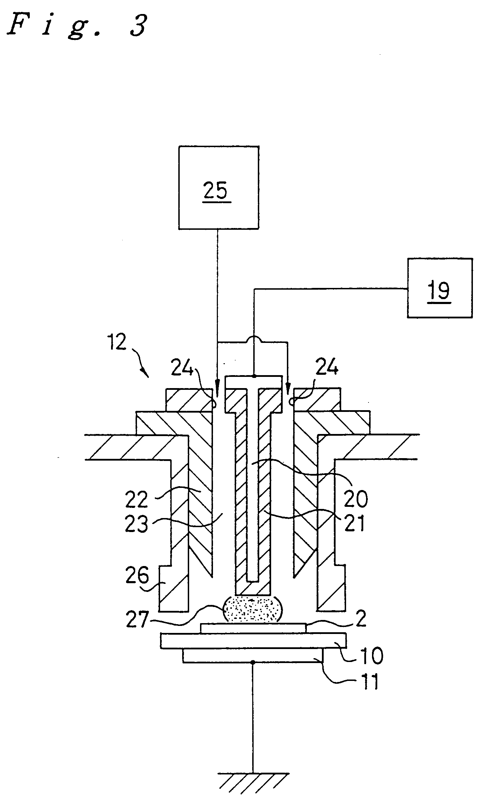

As shown in Fig. 3, the asher 12 has a power supply electrode 20 in the form of a thin plate connected to a high-frequency power source 19 in order to generate a gas discharge under the atmospheric pressure or a pressure near the atmospheric pressure. The power supply electrode 20 is, as shown in Fig. 3, vertically disposed and extends in a direction traversing the guide rails 8, that is, in a direction perpendicular to the direction in which the substrate 2 is moved. The power supply electrode 20 is so inserted into a cover 21 as to be detachable through a top opening of the cover 21, which has a length in the foregoing traversing direction that is at least longer than the diameter of the table 10, and which is made of dielectric material, for example, quartz. A box-like guide member 22 made of insulating material and opened downwards is disposed on the outside of the cover 21 so that a narrow vacant chamber 23 is formed around the cover 21. The vacant chamber 23 has a gas introduction port 24 at the top end thereof so as to be connected to an external gas supply apparatus 25, the vacant chamber 23 having its lower end opened outwards. Thus, a gas passage, through which gas flows downwards from an upper position, is formed for the overall length of the power supply electrode 20. An outer casing 26 is disposed on the outside of the guide member 22, the outer casing 26 being extended to a position near the top surface of the table 10 that passes through a position below the asher 12.

The table 10, on which the substrate 2 has been placed, is allowed to pass through the position below the asher 12 at a predetermined speed by the drive means, as described above. At this time, discharge gas is supplied from the gas supply apparatus 25 to substitute the gas for the in inside the vacant chamber 23. Furthermore, high-frequency voltage is applied from the high-frequency power source 19 to the electrode 20. The grounded base 11 serves as the counter electrode to the power supply electrode 20 so that gas discharge is generated between the lower end of the electrode 20 and the top surface of the substrate 2, as shown in Fig. 3. As a result, an electric circuit is established that passes through the high-frequency power source 19, the power supply electrode 20, the cover 21, a gas-discharge region 27, the substrate 2, the table 10 and the base 11, which is the grounded electrode. At this time, as described above, no discharge takes place in a space surrounded by the guide member 22 which is made of insulating material.

The discharge region 27 is formed straight in a direction perpendicular to the direction in which the substrate 2 is moved. When the table 10 is moved at a predetermined speed, the whole surface of the substrate 2 is exposed to this gas discharge. The activation species/radicals of the discharge gas acts on the whole surface of the substrate 2 under the atmospheric pressure or a pressure near the atmospheric pressure. In another embodiment, non-electrode discharge using microwaves enables a gas discharge to be generated similarly in place of the high-frequency discharge.

Since the base 11 made of an electroconductive material is disposed below the substrate 2 and also the table 10 is so formed as to have a size larger than that of the substrate 2 but smaller than that of the table 10 as described above, direct exposure of the base 11 to the gas discharge can be prevented, but the whole surface of the substrate 2 can be exposed to the discharge region 27. Furthermore, the foregoing structure enables gas discharge to take place stably regardless of whether or not the substrate 2 is made of the electroconductive material. Note that if the substrate 2 is made of glass, the table 10 made of the dielectric material can be omitted from the structure. In this case, the electroconductive base 11 is so formed as to have a size slightly smaller than that of the substrate 2 and the substrate 2 is directly supported on the base 11. If the substrate 2 is made of electroconductive material, it is preferable to ground the substrate 2 through a dielectric member, such as the table 10.

In an experiment using this embodiment, helium discharge gas was used, the frequency of the high-frequency power source 19 was 13.56 MHz, the distance from the power supply electrode 20 to the substrate 2 was 2 mm and the vertical length of the power supply electrode 20 was 200 mm. The helium gas was introduced from the gas supply apparatus 25 into the vacant chamber 23 through the gas introduction port 24 so that helium was substituted for the ambient air near the leading end of the power supply electrode 20. Simultaneously, electric power of the foregoing frequency was supplied from the high-frequency power source 19 to the power supply electrode 20. By applying a suitable voltage to the power supply electrode 20 and selecting a sufficient flow rate of the helium, a uniform discharge state over the whole length of the power supply electrode 20 was realized. It was confirmed that oxygen in the atmosphere (ambient air) left near the discharge region 27 served as activation species, such as oxygen radicals, due to the gas discharge, and reacted with the photoresist on the substrate 2. Thus, the activation species were converted into steam or carbon dioxide which were then vaporized so as to be removed so that ashing was performed. By adding 1 % to 2 % by volume oxygen to the helium, the ashing rate could be made to be further constant. Helium may be used only at the start of the gas discharge, and then compressed air or the like may be supplied after the discharge state has been stabilized.

It is preferable that the quantity of the costly helium gas be reduced so as to reduce the cost. Therefore, the asher 12 of the substrate transfer apparatus 1 according to the present invention has such a structure that the outer casing 26 which extends downwards to such an extent as to cover the substrate 2 prevents easy discharge of helium gas supplied into the vacant chamber 23. On the other hand, to prevent re-adhesion of reaction products produced due to the ashing process to the substrate 2 or the table 10, an excessively closed structure must be avoided. As a result of experiments performed by the inventor of the present invention, it is preferable that a closed state to an extent with which stable gas discharge takes place when the flow rate of the helium gas is made to be 2 to 5 SLM (standard liter/min) be employed.

In this embodiment, the power supply electrode 20 is covered with the cover 21 made of dielectric material, and the table 10, on which the substrate 2 is placed, is made of dielectric material. This effectively prevents an arc discharge and allows realizing a stable gas discharge under the atmospheric pressure. To prevent leakage of high-frequency electromagnetic waves, a grounded metal member is preferably disposed on the outside of the guide member 22. In this case, the guide member 22 must be sufficiently thick to prevent discharge taking place between the grounded metal member and the power supply electrode 20 through the guide member 22.

The power supply electrode 20 is covered with the cover 21 so as to be protected from being oxidized or damaged due to the discharge. The thicker the cover 21 the higher is the electric resistance, and the more the level of the output voltage from the high-frequency power source 19 must be raised, therefore. On the other hand, if the cover 21 is too thin, there arises a risk that the cover 21 encounters insulation breakdown. As a result of the experiments performed by the inventor of the present invention, it is preferable that the thickness of each of the cover 21 and the table 10 be about 0.5 mm to 3 mm though it depends upon the frequency of the power source, the type of the discharge gas, the distance from the power supply electrode 20 to the substrate 2 and the like.

In inverse proportion to the distance from the power supply electrode 20 to the substrate 2, the ashing rate is raised. However, the state of discharge taking place on the surface of the substrate is not always constant because it depends upon the degree of roughness of the surface of the substrate, thin metal portions that may be present on the surface of the substrate and the degree of parallelism between the electrode 20 and the substrate 2 or the substrate conveying system. Significant difference rises in the intensity distribution of the discharge state on the surface of the substrate in inverse proportion to the distance from the electrode to the substrate. If the distance from the electrode to the substrate is lengthened, discharge cannot easily be generated and, thus, the output voltage from the power source 19 must be raised. As a result of experiments performed by the inventor of the present invention, a satisfactory discharge state was realized by setting the distance from the power supply electrode 20 to the substrate 2 to be about 1 mm to 20 mm, preferably about 1 mm to 5 mm.

Then, a gas mixture of nitrogen and 1 % to 2 % by volume oxygen, and atmosphere (compressed air) were used to perform experiments in place of helium. Generally, a high voltage level is required to cause gas discharge to take place in gas except helium or neon. If the frequency of the power source is high, high voltage cannot easily be applied to the electrode. If the frequency of the power source is too low, streamer discharge or arc discharge easily takes place. As a result, charge up takes place on the surface of the substrate to be processed.

Then, experiments were performed under conditions that the frequency of the power source 19 was 13.56 MHz, 400 kHz and 10 kHz, the atmosphere (ambient air) was employed as discharge gas and the distance from the power supply electrode 20 to the substrate 2 was 3 mm. The results were as follows: no gas discharge took place at the frequency of 13.56 MHz, and gas discharge was instable at the frequency of 400 kHz. Although gas discharge took place stably at the frequency of 10 kHz, the gas discharge was a streamer discharge. It was confirmed that if the thickness of the cover 21 disposed on the outside of the electrode 20 was not thick enough, then the gas discharge shifted to arc discharge. Although the substrate can be ashed by the streamer discharge, the results of the processes became irregular. Therefore, under the foregoing conditions, satisfactory results can be obtained in inverse proportion to the frequency and in proportion to the voltage. If the frequency exceeds 400 kHz, practically satisfactory results can be obtained.

When compressed air was horizontally supplied toward the discharge region 27, the discharge was changed from the streamer discharge to the glow discharge. In the foregoing case, the ashing rate was lowered, but the results of the ashing processes did not become irregular as experienced with the streamer discharge. In any case, it is effective because charge up of the surface of the substrate can be prevented in proportion to the frequency of the power source. When compressed air is horizontally supplied toward the discharge region 27 as described above, a further satisfactory result can be obtained.

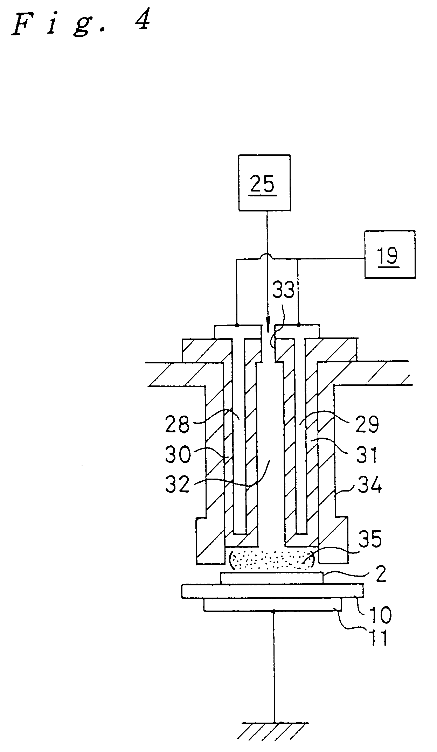

Fig. 4 shows another embodiment of the asher 12. The asher 12 according to this embodiment comprises two power supply electrodes 28 and 29 each of which comprises a electroconductive member in the form of a thin plate similar to the power supply electrode 20 according to the embodiment shown in Fig. 3. The two power supply electrodes 28 and 29 are covered with corresponding covers 30 and 31 each of which is made of dielectric material. The two power supply electrodes 28 and 29 are vertically disposed and extend in a direction perpendicular to the direction, in which the substrate 2 is moved, while being located apart from each other. Thus, a vacant chamber 32 is formed between the two power supply electrodes 28 and 29. The vacant chamber 32 has the top end connected to the gas supply apparatus 25 through a gas introduction port 33, the lower end of the vacant chamber 32 being opened toward the top surface of the substrate 2. A box-like casing 34 made of insulating material is disposed on the outsides of the covers 30 and 31 for the power supply electrodes 28 and 29. The lower end of the casing 34 so extends to a position near the top surface of the substrate 2 as to cover the substrate 2.

By applying high-frequency voltages from the power source 19 to the two power supply electrodes 28 and 29 while supplying the discharge gas from the gas supply apparatus 25 into the vacant chamber 32, gas discharge takes place between the two power supply electrodes 28 and 29 and the substrate 2. In this embodiment, two power supply electrodes are employed so that a larger discharge region 35 can be obtained, and therefore a larger substrate area can be processed at a time.

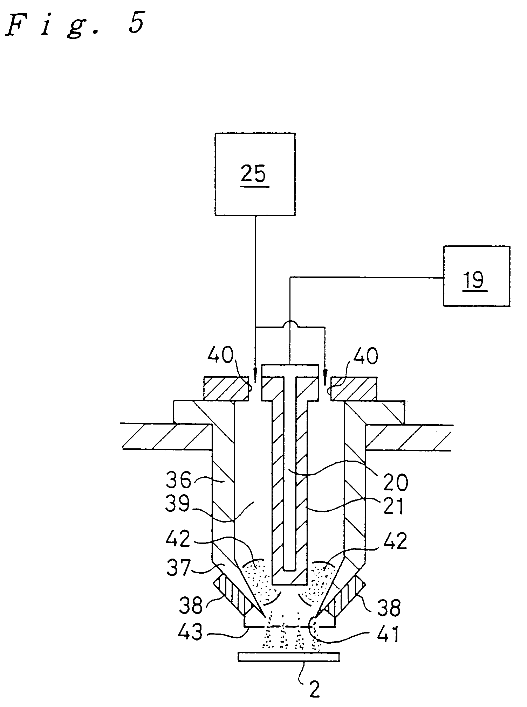

Fig. 5 shows another embodiment of the asher 12 that is capable of ashing the substrate 2 while protecting the substrate 2 from being directly exposed to the gas discharge. The asher 12 according to this embodiment has a similar electrode structure as that of the embodiment shown in Fig. 3 such that a thin plate-like electrode 20 connected to the high-frequency power source 19 is detachably inserted into the cover 21 made of dielectric material through the top end of the cover 21. The electrode 20 is vertically disposed and extends in a direction perpendicular to the direction, in which the substrate 2 is moved. A guide member 36 made of insulating material is so disposed on the outside of the cover 21 as to face the two outside surfaces of the cover 21 at predetermined short intervals. A lower end portion 37 of the guide member 36 is inwardly inclined, and the leading end of the lower end portion 37 extends to a position lower than the leading end of the power supply electrode 20. A pair of grounded electrodes 38 serving as the counter electrodes to the power supply electrode 20 are applied to the outer surface of the lower end portion 37.

A vacant chamber 39 is formed between the cover 21 and the guide member 36, the top end of the vacant chamber 39 being connected to an external gas supply apparatus 25 through a gas introduction port 40. The lower end of the vacant chamber 39 is opened outwardly through a narrow and straight shape gas jetting out port 41 formed by the lower end portion 37 of the guide member 36. When the discharge gas is supplied from the gas supply apparatus 25 into the vacant chamber 39 and a high-frequency voltage is applied from the high-frequency power source 19 to the electrode 20, gas discharge takes place in the vacant chamber 39 at a position between the power supply electrode 20 and the grounded electrodes 38 as illustrated. Therefore, this embodiment enables eliminating the grounded electrode, such as the base 11 of Fig. 3, below the substrate 2 and the substrate 2 is placed on the dielectric table 10.

By supplying, for example, helium containing 1 % to 2 % by volume oxygen, nitrogen gas similarly containing 1 % to 2 % oxygen or compressed air as the discharge gas, oxygen activation species required for the ashing process are produced in the discharge region 42. The oxygen activation species are formed into a gas flow due to continuous supply of the discharge gas from the gas supply apparatus 25, the gas flow being downwards jetted out toward the surface of the substrate 2. As a result, the surface of the substrate 2 can be ashed. When the gas flow is jetted out with the substrate 2 being moved from the sender cassette 3 to the receiver cassette 4, the whole surface of the substrate 2 can be processed even if the substrate 2 has a large diameter.

Since the substrate 2 is not directly exposed to the discharge region 42 in this embodiment, ashing can be performed relatively uniformly even if stable glow discharge does not take place but streamer discharge takes place depending upon the frequency of the power source or the type of the activation species/radicals. As a matter of course, the difference in the quantity for producing the oxygen activation species depending upon the type of the discharge results in the difference in the ashing rate. If compressed air is used as the discharge gas, raising of the flow velocity enables streamer discharge to be prevented. Furthermore, lowering of the frequency of the power source will reduce the cost without a necessity of using helium gas. If a grounded metal mesh 43 is provided for the gas jetting out port 41, ions and electrons in the plasma contained in the gas flow can be trapped and neutralized. Thus, charge up of the surface of the substrate 2 can be prevented.

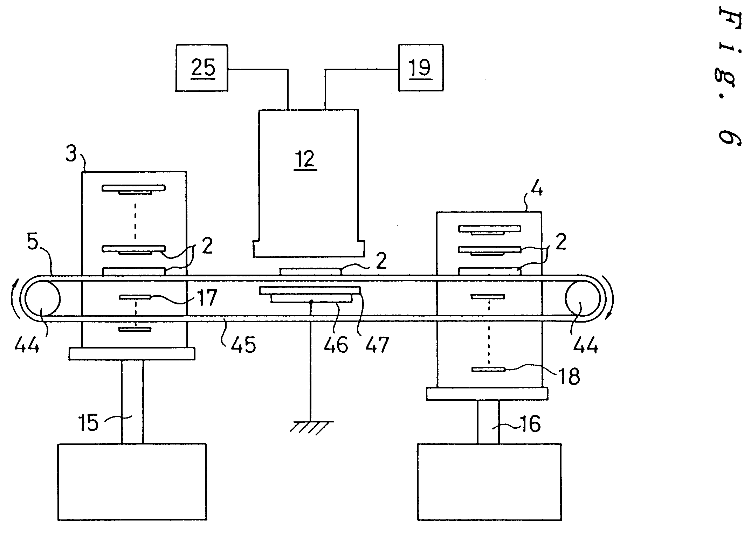

Fig. 6 shows another embodiment of the substrate transfer apparatus according to the present invention. In this embodiment, the conveyor means 5 comprises an endless conveyor belt 45 that is moved in a direction indicated by arrows at a predetermined speed by two drive rollers 44. The conveyor belt 45 is so operated as to pass through the two cassettes 3 and 4 while always maintaining a predetermined level. The substrates 2 accommodated in the sender cassette 3 can be, one by one, placed on the conveyor belt 45 so as to be conveyed consecutively by continuously moving downwards the sender cassette 3 by the lifting apparatus 15 at predetermined intervals, conveyance being started with the substrate 2 in the lowermost position of rack 17. The substrates 2 conveyed into the receiver cassette 4 are, one by one, accommodated by continuously moving upwards the receiver cassette 4 by the lifting apparatus 16 at predetermined intervals in such a manner that accommodation of the substrates 2 on the conveyor belt 45 starts at the uppermost position of rack 18.

The asher 12 is disposed at an intermediate position between the two cassettes 3 and 4, the intermediate position being a position just above the conveyor belt 45 with a slight gap maintained from the substrate 2 placed on the belt. This embodiment is different from the embodiments shown in Figs. 1 to 3 such that a grounded electrode 46 corresponding to the base 11 of Fig. 3 and a dielectric member 47 interposed between the grounded electrode 46 and the substrate 2 are not disposed above the conveyor belt 45 but are disposed and secured just below that run of the conveyor belt 45 that passes through a position below the asher 12. Therefore, the asher 12 is capable of always generating gas discharge between itself and the dielectric member 47 regardless of whether or not the substrate 2 placed on the conveyor belt 45 passes through a position below the asher 12. When a substrate 2 placed on the conveyor belt 45 passes through the discharge region 48, the substrate 2 is ashed. The substrate 2 may be processed in such a manner that the conveyor belt 45 is stopped in the discharge region 48. If the asher 12 has the structure shown in Fig. 5, the grounded electrode 46 and the dielectric member 47 may, of course, be omitted from the structure.

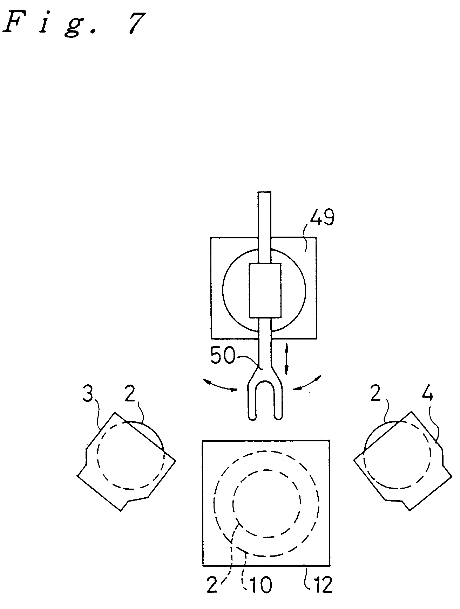

Fig. 7 shows another embodiment of the substrate transfer apparatus according to the present invention. In this embodiment, the conveyor apparatus comprises one loader/unloader 49. The loader/unloader 49 comprises a telescopic rotative arm 50 having the same structure as that of the loader 7 and the unloader 6 shown in Fig. 2 and is operated similarly so as to take out the substrate 2 from the sender cassette 3 and load it into the receiver cassette 4. The asher 12 having the structure shown in Fig. 3 is disposed between the two cassettes 3 and 4, while the table 10 made of dielectric material and a grounded electrode are secured at positions below the asher 12. The loader/unloader 49 places the substrate 2 taken out from the sender cassette 3 on the table 10 before it conveys the substrate 2 to the receiver cassette 4. After the substrate 2 has been ashed by operating the asher 12, the loader/unloader 49 picks up the substrate 2 from the table 10 to convey the substrate 2 into the receiver cassette 4.

The conveying means according to the foregoing embodiments may be any of various means that have been employed to transfer substrates. The apparatus for transferring substrates according to the present invention is not limited to the object of the foregoing embodiments such that the residual resist after the dry etching process has been performed is removed. The transfer apparatus according to the present invention may be used as an asher of a transfer apparatus of a cassette to cassette type for removing organic substances to prevent contamination of substrates.

By changing the type of the discharge gas to meet the desire of the processing steps before and after the moment the substrate has been transferred, the asher according to the foregoing embodiments can be used to perform surface treatments other than the ashing process. For example, helium, nitrogen or the like is used so that the surface of the substrate is given wettability. By using a gas mixture of CF₄ and helium or the like, etching can be performed. By using gas, such as CF₄ or SF₆ containing fluorine, the surface of the substrate can be made water repellent.

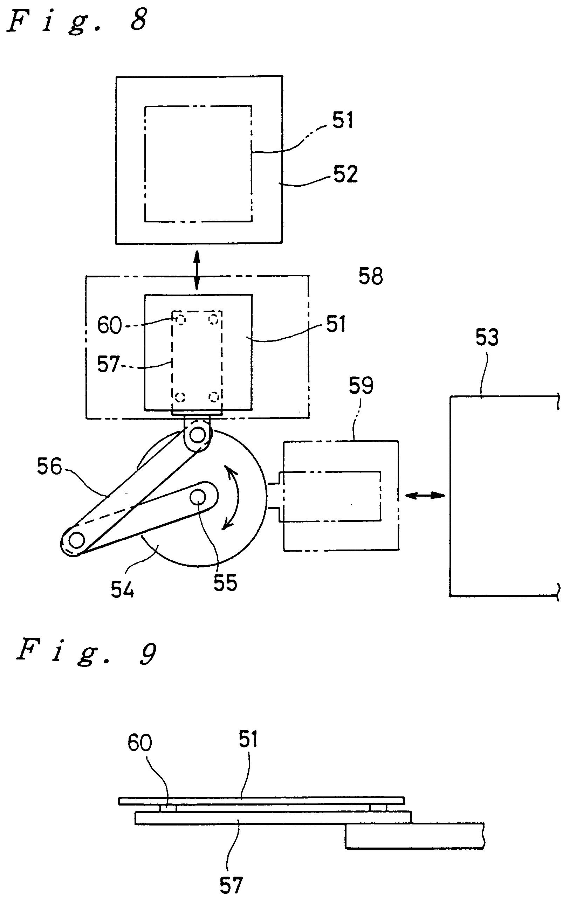

An apparatus and a method of processing substrates according to the present invention will now be described with reference to Figs. 8 to 11, with which the conveying mechanism or its portions that are brought into contact with the substrates can be, in the field, washed by means of surface treatment using the atmospheric-pressure plasma without a necessity of removal of the conveying mechanism.

An apparatus for processing substrates shown in Fig. 8 comprises a robot 54 for conveying substrates 51 for liquid crystal display panels from a cassette 52 into a processing chamber 53. In the processing chamber 53, any one or more of a variety of processes, such as film forming, etching, application of photoresist or development of the surface of the substrate 51, or any one or more of a variety of inspections of, for example, appearance, dimensions, thickness, resistance value, electric characteristics or the like, of the substrate 51 can be performed. The robot 54 comprises a conveying arm 57 connected to a rotational shaft 55 through a linkage mechanism 56. A surface treatment portion 58 is disposed between the cassette 52 and the robot 54 in such a manner that the surface treatment portion 58 is located along the passage, through which the substrates 51 are conveyed, and just above the conveying arm 57 The surface treatment portion 58 has a structure similar to that of the asher shown in Fig. 5 so as to be capable of causing gas discharge to take place by using discharge gas of, for example, helium, containing oxygen, under the atmospheric pressure or a pressure near the atmospheric pressure so that a gas flow including the activation species/radicals is jetted out.

The robot 54 rotates the rotational shaft 55 to extend the conveying arm 57 so as to take out, one by one, the substrates 51 accommodated in the cassette 52, and to move the substrate 51 to a position 59 in front of the processing chamber 53 indicated by a dashed line of Fig. 8, followed by extending the conveying arm 57 to transfer the substrate 51 into the processing chamber 53. The substrate 51, that has been processed in the processing chamber 53, is again taken out by the conveying arm 57 so as to be returned into the cassette 52. In another embodiment, the substrate taken out from the processing chamber 53 may be accommodated in another cassette. In a case where a plurality of processing chambers are provided for one processing apparatus in order to consecutively subject one substrate to a plurality of processes, the substrate taken out from the processing chamber 53 is moved to the next processing chamber by the robot 54.

Four support portions 60 are so formed on the top surface of the conveying arm 57 as to project over the top surface as collectively shown in Fig. 9 so that the reverse surface of the substrate 51 is directly supported and the substrate 51 is conveyed. Each of the support portions 60 is provided with a mechanism for vacuum-chucking the substrate 51, if necessary. The portions of the conveying arm, that are brought into contact with the substrate, are usually made of rubber resin. If necessary, heat-resisting rubber, ceramic, such as alumina, or metal, such as SUS, is employed. It is preferable that the support portions 60 according to this embodiment, that are dry-washed as explained below, be made of ceramic or metal.

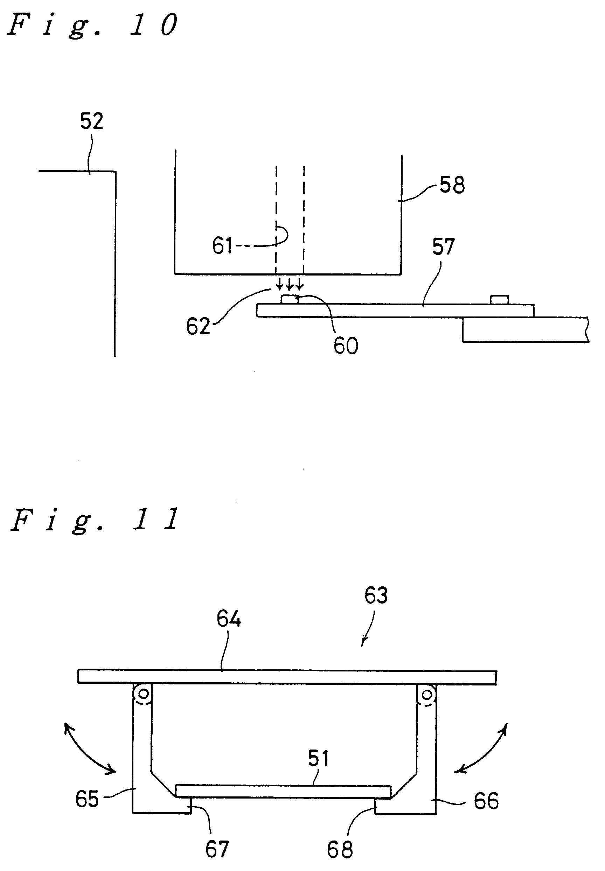

In this embodiment, when the conveying arm 57 is moved toward the cassette 52 to take out the substrate, gas discharge takes place in the surface treatment portion 58 so that the support portions 60 on the top surface of the conveying arm 57 are dry-washed as shown in Fig. 10. This process may be performed either by stopping the conveying arm 57 when a gas flow 62 jetted out through a jetting-out port 61 formed in the lower surface of the surface treatment portion 58, and including the activation species/radicals of the discharge gas, and the position of each of the support portions 60 are aligned to each other, or while the conveying arm 57 is being moved. In an experiment using this embodiment of the invention. as the discharge gas, helium of a flow rate of several SLM to a dozen of SLM and oxygen, the flow rate of which was several % to tens of % of that of the helium were used while a high-frequency electric power of tens to several hundred of watts was applied, the frequency of which was 13.56 MHz. Thus, a gas flow including a multiplicity of oxygen activation species/oxygen radicals was applied to degrease and wash the support portions 60. The distance from the jetting-out port 61 to the support portions 60 is preferably several mm.

Contamination by organic substances or the like, which have adhered to the reverse side of the substrate when the substrate has been subjected to a variety of processes in the manufacturing process, adheres to and deposits on the support portions 60, that are brought into direct contact with the substrate. The surface treatment, to which the support portions 60 are subjected, eliminates the risk of shift of the contamination to another substrate that is conveyed next or the risk of contamination of another processing apparatus. Thus, the manufacturing yield of the semiconductor apparatuses can be improved. It is convenient to periodically perform the process of washing the conveying arm 57 while considering the number of the conveyed substrates and the operation period. For example, if the washing process is performed during the stoppage of the conveying arm for changing the cassette 52, then deterioration in the through-put of the processing apparatus can efficiently be prevented.

In another embodiment, the surface treatment portion 58 may be disposed at extra processing position outside of the passage through which the substrates are conveyed. In this case, the conveying arm 57 is moved to the extra processing position during the change of the cassette so that the support portions 60 are washed. The surface treatment portion, that is fixedly disposed in this embodiment, may be made movable, and the conveying arm may be stopped or moved as desired to perform scanning so as to dry-wash the support portions. In another embodiment, the cassette 52 may be made movable, and it may be dry-washed by the surface treatment portion 58, and then be returned to another position.

Fig. 11 shows another embodiment of the conveying arm provided for the robot 54. The conveying arm 63 comprises hooks 65 and 66 disposed below and secured to a portion 64 that is connected to the linkage mechanism 56, the hooks 65 and 66 being so attached (pivotally in the embodiment shown) as to be capable of opening to the right and left. The substrate 51 is conveyed while having the two sides thereof supported by support portions 67 and 68 at the leading portions of the corresponding hooks 65 and 66. Also in this case, the surface treatment portion 58 is disposed along the passage through which the substrate is conveyed, or at an extra processing position so that the conveying arm 63 is dry-washed without removal of the same from the robot 54. Thus, contamination of organic substances or the like allowed to adhere to each of the support portions 67 and 68 from the reverse side of the substrate can be removed.

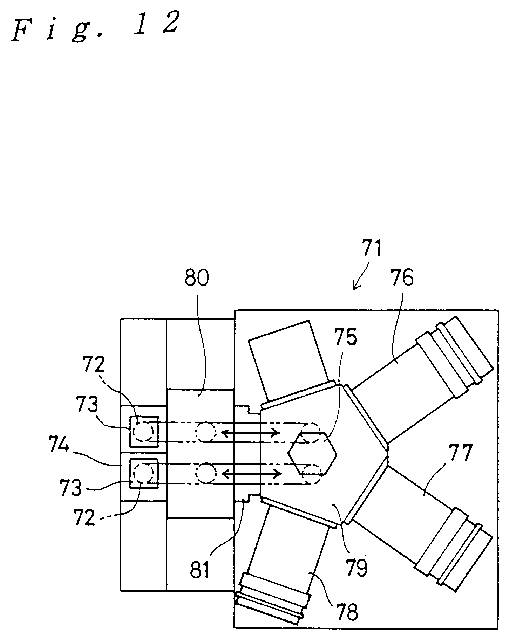

Figs. 12 to 15 show preferred embodiments of the apparatus for processing substrates, each of which comprises a surface treatment portion using an atmospheric-pressure plasma and formed integrally and which is capable of consecutively and automatically performing a sequence of processing steps.

Fig. 12 schematically illustrates a preferred embodiment of a sputtering apparatus to which the present invention is applied. A sputtering apparatus 71 comprises a cassette loader 74, on which two cassettes 73 each accommodating a multiplicity of substrates (wafers) 72 are placed; and a vacuum chamber 79 including a robot 75 having two conveying arms for introducing/discharging the substrates 72 to and from the two cassettes 73, the vacuum chamber 79 further including first to third sputtering chambers 76 to 78 disposed around the robot 75 and capable of sputtering different metals. A surface treatment portion 80 is disposed between the cassette loader 74 and the vacuum chamber 79, the surface treatment portion 80 being located above the passage, through which the substrates 72 are conveyed. The surface treatment portion 80 has a structure similar to that of the asher 12 shown in Figs. 3 to 5 so as to generate a gas discharge under the atmospheric pressure or a pressure near the atmospheric pressure by using discharge gas of, for example, helium, containing oxygen.

The substrates 72 are, one by one, taken out from the respective cassette 73 by the robot 75, followed by being passed through a valve 81 so as to be conveyed into the vacuum chamber 79. The surface treatment portion 80 is caused to discharge electric charge so that a straight discharge region is created in a direction perpendicular to the direction in which the substrates 72 are conveyed or a gas flow including activation species/radicals is jetted out, similarly to the embodiments shown in Figs. 3 to 5. Thus, the surface of the substrate 72, which passes through a position below the surface treatment portion 80, is exposed to the oxygen activation species/oxygen radicals. As a result, the substrate 72 is dry-washed as the pre-process for the sputtering operation so that organic substances and the like are removed from the surface of the substrate 72. By this, the contact between the surface and the sputter film can be improved.

The substrate 72 conveyed into the vacuum chamber 79 is, by the robot 75, transferred into the first sputtering chamber 76 so that a Ti film is formed by sputtering. Then, the substrate 72 is transferred to the second sputtering chamber 77 so that a TiN film is formed on the Ti film. Then, the substrate 72 is, by the robot 75, caused to pass through the valve 81 from the vacuum chamber 79 so as to be conveyed back to the surface treatment portion 80. The surface treatment portion 80 is again caused to discharge electric charge so that the surface of the TiN film of the substrate 72 disposed below the surface treatment portion 80 is exposed to oxygen activation species/oxygen radicals so as to be oxidized. By forming the oxidized film on the surface of the TiN film as described above, the barrier characteristic can be improved and alloy spikes can be prevented. Then, the substrate 72 is returned to the vacuum chamber 79 so as to be transferred to the third sputtering chamber 78 so that an Al-Cu film is formed on the TiN film. Then, the substrate 72 is again transferred to the second sputtering chamber 77 so that a TiN film is formed on the Al-Cu film. The substrate 72, which has been subjected to the sputtering film forming processes, is, by the robot 75, passed through the valve 81 so that the substrate 72 is returned to the original cassette 73 of the cassette loader 74. As will be understood films of materials other than those mentioned above and/or in a different order may of course be formed by this embodiment.

The sputtering apparatus according to this embodiment has the surface treatment portion using atmospheric-pressure plasma that is provided for the transfer structure for conveying substrates between the cassette and the vacuum chamber. Thus, the film forming process consisting of a sequence of steps of sputtering, ashing and sputtering can be automatically and consecutively performed. As a result, the necessity raised with the conventional structure that the asher requiring a vacuum equipment is disposed separately from the sputtering apparatus can be eliminated. Therefore, the manufacturing process can be automated and rationalized, and thus the cost can be reduced. Furthermore, the substrate cannot easily be contaminated due to the consecutive process so that the yield is improved, and the productivity and the reliability are improved.

The structure according to this embodiment enables the conveying arm of the robot 75 can be dry-washed in the field without a necessity of removing the conveying arm. That is, the surface treatment portion 80 is caused to discharge electric charges and the empty conveying arm having no substrate placed thereon is moved so that the conveying arm is exposed to oxygen activation species/oxygen radicals. As a result, contamination of organic substances shifted from the substrate, which is being conveyed, and allowed to adhere to the conveying arm can be removed. Thus, the re-contamination of the substrate can be prevented without a fear of deterioration in the throughput.

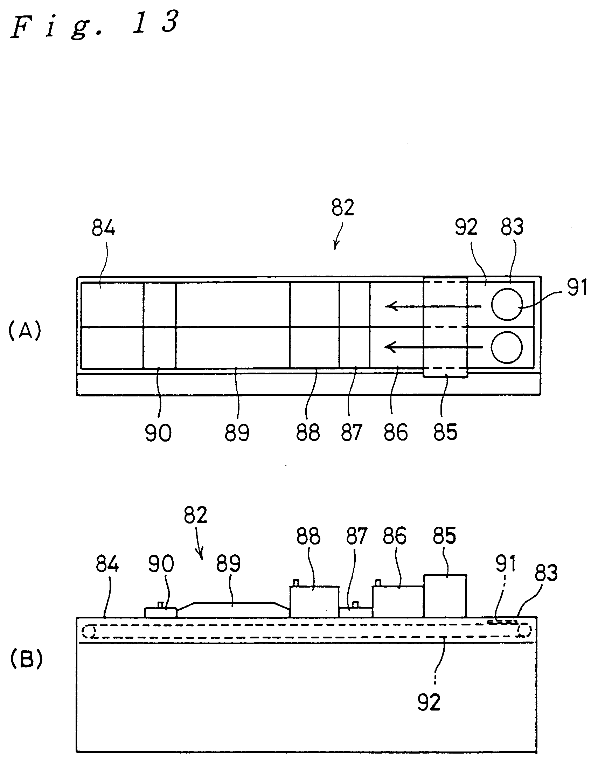

Figs. 13A and 13B schematically show a preferred embodiment of an apparatus for forming a resist film to which the present invention is applied. A resist-film forming apparatus 82 comprises, between a sender portion 83 formed at one end thereof and a receiver portion 84 formed at another end thereof, a surface treatment portion 85 using atmospheric-pressure plasma; a pre-processing portion 86 for improving contact of the resist film; a cooling portion 87 comprising a cooling plate; a resist-applying portion 88 for applying photoresist resin to the surface of the substrate; a heating portion 89 comprising a heating plate; and a cooling portion 90 comprising a cooling plate, the foregoing portions being disposed in the sequence of the processes. A multiplicity of substrates (wafers) 91 are respectively placed on two conveyor belts 92 so as to be horizontally conveyed from the sender portion 83 to the receiver portion 84 so that the substrates 91 are consecutively processed by the respective processing portions.

The surface treatment portion 85, similarly to the sputtering apparatus shown in Fig. 12, has a structure similar to that of the asher shown in Figs. 3 to 5 so as to use discharge gas of helium or the like containing oxygen to generate gas discharge under the atmospheric pressure or a pressure near the atmospheric pressure. The surface of each of the substrates 91 is exposed to oxygen activation species/oxygen radicals generated due to the gas discharge so that the surface is given hydrophilic nature. Then, processes similar to the conventional method are performed so that a resist film is formed on the surface of the substrate 91. Since the hydrophilic nature is, as described above, previously given to the surface of the substrate 91 on which the resist film will be formed, etching solution can easily be applied to the surface of the substrate 91 in a following wet etching process. Therefore, etching can satisfactorily be performed, and therefore the yield can be raised and the productivity can be improved.

The structure according to this embodiment enables the conveyor belt 92 for conveying the substrates and the like to be washed with oxygen activation species/oxygen radicals simultaneously with the process of the substrates 91 performed by the surface treatment portion 85. In another embodiment, change of the discharge gas for use in the surface treatment portion 85 will enable the surface of the substrate to have characteristics other than the hydrophilic nature. If argon or nitrogen is used as the discharge gas, the surface of the substrate can be subjected to surface treatment to improve contact with the resist film. By using an appropriate gas as the discharge gas, the surface of the substrate can be modified to a desired characteristic corresponding to the employed gas.

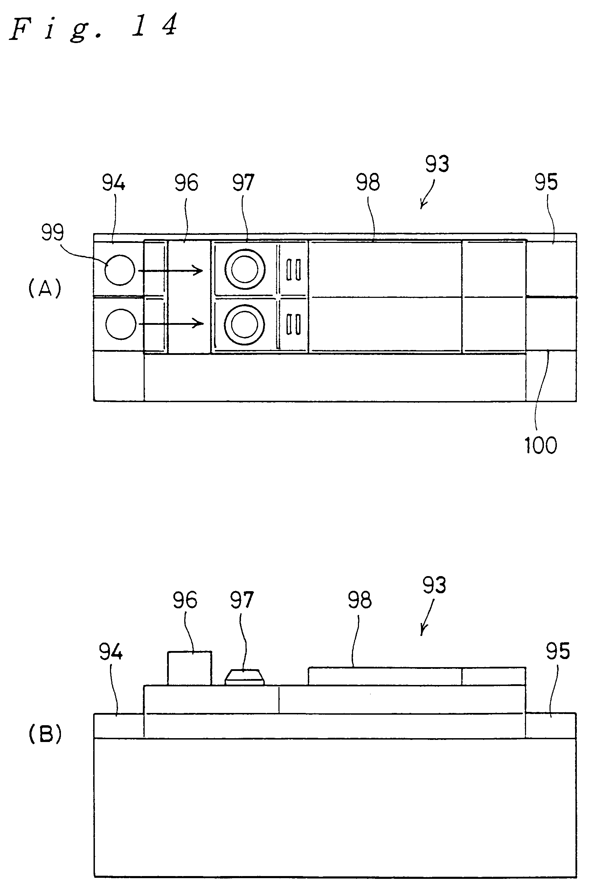

Figs. 14A and 14B schematically show a preferred embodiment of a wet etching apparatus to which the present invention is applied. A wet etching apparatus 93 comprises, between a sender portion 94 formed at one end thereof and a receiver portion 95 formed at another end thereof, a surface treatment portion 96 using atmospheric-pressure plasma; a processing chamber 97 for performing an etching process with etching solution introduced thereto; and a washing portion 98. A multiplicity of substrates 99 are respectively placed on two conveyor belts 100 so as to be horizontally conveyed from the sender portion 94 to the receiver portion 95 so that a sequence of processes required to perform wet etching are consecutively performed.

Initially, the surface treatment portion 96 is operated to pre-process the surface of the substrate 99. The surface treatment portion 96 has a structure similar to that of the asher 12 shown in Figs. 3 to 5 so as to generate gas discharge with discharge gas of helium or the like containing oxygen under the atmospheric pressure or pressure near the atmospheric pressure. The substrates 99 are exposed to oxygen activation species/oxygen radicals generated due to the discharge so that the resist film of the substrate 99 is given hydrophilic nature. As a result, the etching solution can easily be applied when the etching process is performed in the processing chamber 97 immediately after the exposure has been performed. Thus, the etching process can be performed satisfactorily. Therefore, the yield can be improved, and the necessity raised with the conventional method that the substrate is transferred between the wet etching apparatus and the asher can be eliminated. As a result, contamination occurring during the transference of the substrates can be prevented, and the manufacturing process can be rationalized. The etched substrate 99 is subjected to a water washing process with pure water or the like in the washing portion 98, followed by being conveyed to receiver portion 95.

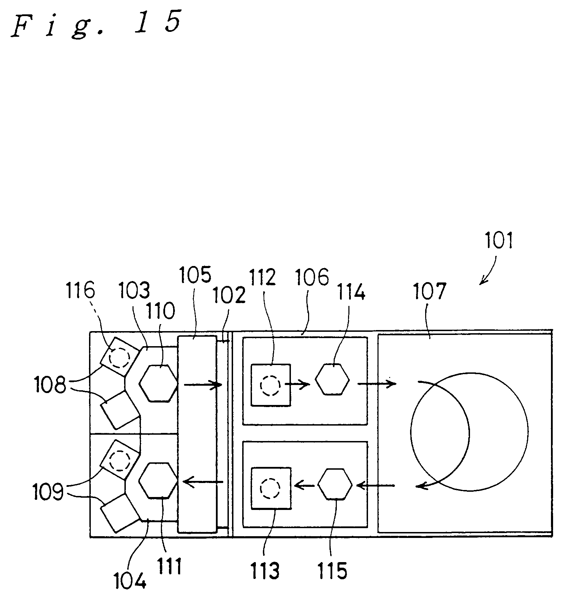

Fig. 15 schematically shows a preferred embodiment of a dry etching apparatus to which the present invention is applied. A dry etching apparatus 101 comprises, on the atmospheric pressure side thereof through a valve, a substrate inlet portion 103, a substrate outlet portion 104, and a surface treatment portion 105. The dry etching apparatus 101 comprises, on the vacuum side thereof, a vacuum chamber 106 and an etching chamber 107. The substrate inlet portion 103 and the substrate outlet portion 104 respectively comprise robots 110 and 111 each having a conveying arm for introducing/discharging the substrate and disposed between two sender cassettes 108, on which the substrates that have not been etched are placed, and two receiving cassettes 109 for accommodating etched substrates. To correspond to the foregoing units, the vacuum chamber 106 includes buffer cassettes 112 and 113 for temporarily accommodating substrates received from the sender cassette 108 and to be transferred to the receiver cassette 109; and robots 114 and 115 each having a conveying arm for conveying the substrates between each of the buffer cassettes 112 and 113 and the etching chamber 107. The surface treatment portion 105 has a structure similar to that of the asher 12 shown in Figs. 3 to 5 so as to generate gas discharge under the atmospheric pressure or pressure near the atmospheric pressure by using discharge gas of helium or the like containing oxygen.

The substrates 116 in each of the sender cassettes 108 are taken out by the robot 110, one by one, followed by being passed through the surface treatment portion 105 and the valve 102. Thus, all substrates 116 are placed on the transmission-side buffer cassette 112. At this time, the surface treatment portion 105 is caused to perform gas discharge so that the surface of each substrate 116, that is passed through a position below the surface treatment portion 105, is exposed to oxygen activation species/oxygen radicals. Thus, scum on the surface of the resist film can be removed. The substrates 116 in the buffer cassette 112 are taken out by the robot 114, one by one, so as to be conveyed to the etching chamber 107. After the substrates 116 have been etched, the substrates 116 are, by the robot 115, returned to the receiving-side buffer cassette 113. The substrates 116 in the receiving-side buffer cassette 113 are taken out by the robot 111, one by one, so as to be again passed through the surface treatment portion 105 and the valve 102, followed by being placed on the receiver cassette 109.

The surface treatment portion 105 causes gas discharge to take place by using, as the discharge gas, mixed gas of a gas containing fluorine, such as CHF₃ or CF₄, and oxygen. Thus, the surface of the substrate 116 is exposed to the activation species/radicals of the mixed gas. As a result, a water-repellent coating film is formed on the surface of the etched substrate 116. Thus, if Cl components contained in the reaction gas for use in the dry etching process are left on the surface of the substrate, the substrate is subjected to a corrosion-prevention process to prevent contact of the atmosphere or water in the atmosphere. Then, the discharge gas is changed to mixed gas of helium and oxygen so as to be discharged, and then the substrate 116 is, while being placed on the conveying arm of the robot 111, passed through a position below the surface treatment portion 105. As a result, the surface of the substrate 116 is exposed to oxygen activation species/oxygen radicals generated due to the discharge, and the resist film on the surface is separated by ashing.

In the ashing process, the discharge gas may comprise mixed gas of alcohol, such as methanol, and oxygen. In another embodiment, mixed gas of alcohol, such as methanol, and oxygen is used so that the substrate 116, which is conveyed from the vacuum chamber 106 by the robot 111, is simultaneously subjected to the corrosion-resistance process for removing the Cl components and ashing of the resist film using oxygen activation species/oxygen radicals with only one surface treatment process. In the foregoing case, it is preferable that undesired contact with the atmosphere (in particular, water in the atmosphere) be prevented until the completion of the surface treatment by flowing nitrogen gas along the surface of the substrate 116 or by narrowing the gap between the surface of the substrate 116 and the surface treatment portion 105 to prevent introduction of the atmosphere and by heating the substrate 116 to 200°C or higher to enhance removal of the Cl components. If a resist film is left on the surface of the substrate 116 placed in the receiver cassette 109, another apparatus is required to remove the resist film by wet etching.

The dry etching apparatus according to this embodiment comprises the surface treatment portion 105 using atmospheric-pressure plasma that is integrally disposed between the substrate inlet portion 103, the substrate outlet portion 104 and the vacuum chamber 106. As a result, the necessity of providing another asher or conveying the substrate to and from the asher can be eliminated. Thus, the apparatus can be made compact, and the manufacturing process can be rationalized. Furthermore, a risk of the contamination of the substrate during conveyance can be overcome so that the manufacturing yield and the reliability are improved.

The structure according to this embodiment enables the conveying arms of the robots 110 and 111 to be dry-washed by the surface treatment portion 105. That is, discharge gas of helium or the like containing oxygen is used to cause gas discharge to take place, and the empty conveying arm having no substrate placed thereon is made to pass through a position below the surface treatment portion 105 so as to expose the surface of the conveying arm to oxygen activation species/oxygen radicals. As a result, contamination of organic substances or the like shifted from the conveyed substrate and allowed to adhere to the conveying arm can be removed. Since the conveying arm can be washed without a necessity of removing the same, deterioration in the throughput can be prevented and the re-contamination of the substrate can effectively be prevented.

Although the invention has been described in its preferred form, it is understood that the present disclosure of the preferred form can be changed in the details of construction and the combination and arrangement of parts may modified. For example, the structures of the sputtering apparatus, the resist-film forming apparatus, and wet- or dry-etching apparatus may be modified with respect to those shown in Figs. 12 to 15.

The present invention may be applied to any of a variety of processing apparatuses, such as an apparatus for forming a silicon oxide film by a CVD method, silicon nitride film, polycrystal silicon film, amorphous film or silicon film; an apparatus for forming an insulating film, such as SOG, PSG, BPSG, by a spin coating method; and an ion implantation apparatus for implanting, to the surface of the substrate, ions of phosphorus, boron, arsenic or the like. The present invention may as well as be applied to a means for measuring the thickness, dimensions, the resistance and the like of the formed film; a means for inspecting the electric characteristic of the device or the appearance or the defects of the substrate. Furthermore, the surface treatment portion using the atmospheric-pressure plasma can be provided integrally with a processing apparatus that is capable of consecutively performing a plurality of processes, such as a film forming process, a resist-film forming process, an etching process, a process for injecting impurities or an inspection process, as well as the foregoing specific processes or inspections.

The present invention enables a cleaning portion to be provided for each of the foregoing processing or inspection apparatuses, the cleaning portion using atmospheric-pressure plasma to clean a stage or a table secured to receive or hold a substrate or a substrate. By providing the self-cleaning function that is performed under room temperature and atmospheric pressure and that can be completed in a short time, the cleaning operation can be frequently performed without actual deterioration in the throughput. Therefore, the productivity and the reliability can be improved.

Combinations among the features of the various embodiments described above are considered disclosed by this specification even if such combinations have not been specifically mentioned and/or are not shown in any of the drawings.

As a result of the foregoing structures, the following effects can be obtained.

According to the apparatus for processing substrates claimed in claim 1, the variety of processes, such as sputtering and etching of the substrates, inspections of the electric characteristics or the like, conveyance, and the pre- or post-process using plasma generated due to the gas discharge under the atmospheric pressure can consecutively be performed. Furthermore, any vacuum facility for performing the pre- or post-process is not required. Therefore, the overall body of the apparatus can be integrally constituted, and the same can be simply formed with a low cost. Furthermore, the manufacturing process can be rationalized so that the cost is reduced and the productivity is improved.

Furthermore, according to the apparatus for processing substrates claimed in claim 2, the pre-or post-process can be performed during the process for conveying the substrates so as to be processed or inspected. Therefore, the manufacturing process can further be rationalized.

According to the method of processing substrates claimed in claim 6, the process for washing the conveying mechanism can be performed in the field by the plasma process, which does not require any vacuum facility and which is performed under the atmospheric pressure without removal of the portions of the conveying mechanism that are brought into direct contact with the substrate. Therefore, the consecutive processes or inspections of the substrates cannot substantially be interrupted. Since re-contamination of the substrates from the conveying mechanism can be prevented without deterioration in the throughput, the manufacturing process can be rationalized and the yield can be improved. Thus, the cost can be reduced, and the productivity can be improved. According to the apparatus for processing substrates claimed in claim 11, the washing means does not require a vacuum facility. Therefore, an in-line system can easily be formed so that the processing method claimed in claim 9 is easily realized. Furthermore, the structure of the overall body of the apparatus can be simplified and the size of the same can be reduced. Thus, the space for installation can be reduced, and the cost can be reduced.

According to the apparatus for processing substrates claimed in claim 11, the cleaning means cleans the means, such as a stage or a table, for holding the substrate by using activation species/radicals generated due to the gas discharge under the pressure in the vicinity of the atmospheric pressure. Thus, a complicated operation required with the conventional structure can be omitted to efficiently perform self-cleaning without substantial deterioration in the throughput. As a result, the cleaning process can be performed more frequently as compared with the conventional structure. Consequently, the productivity and the reliability can be improved.

According to the substrate transfer apparatus claimed in claim 12, the ashing process is performed under the pressure near the atmospheric pressure. Therefore, any vacuum facility is not required, and the overall body of the apparatus can be simplified and the size of the same can be reduced. Therefore, an in-line system with the transfer apparatus can easily be formed so that the ashing process is consecutively performed during the process in which a plurality of the substrates are sequentially transferred from one of the cassettes to the other cassette. As a result, the operation can be facilitated, the processing time can be shortened, the cost can be reduced, and the productivity can be improved. Furthermore, the size reduction enables the space for the clean room to be used effectively.

Furthermore, according to the substrate transfer apparatus claimed in claim 13, the surface of the substrate can satisfactorily be ashed by the stable gas discharge without arc discharge. Since the grounded electrode is not directly exposed to the gas discharge, damage of the electrode due to the discharge can be prevented. Thus, the operation for maintaining the apparatus can be satisfactorily omitted, and the cost for the maintenance can be reduced.

According to the substrate transfer apparatus claimed in claim 16, the ashing process is performed in such a manner that the activation species/radicals generated due to gas discharge generated under the pressure in the vicinity of the atmospheric pressure are formed into a gas flow to which the substrate is exposed. Therefore, the surface of the substrate can uniformly be processed regardless of the frequency of the power source or the type of the gas employed.

Although the invention has been described in its preferred form with a certain degree of particularity, it is understood that the present disclosure of the preferred form can be changed in the details of construction and the combination and arrangement of parts may be resorted to without departing from the spirit and the scope of the invention as hereinafter claimed.

## Claims

1. An apparatus for processing substrates, comprising:
means for processing or inspecting substrates;
means for conveying said substrates toward said processing or inspecting means or from said processing or inspecting means; and
means for subjecting said substrates to a surface treatment as a pre-process or post-process of said process or inspection,
wherein said surface treatment means includes means for causing gas discharge to take place in a predetermined discharge gas under the atmospheric pressure or a pressure near the atmospheric pressure so as to expose said substrates to activation species/radicals of said discharge gas generated due to the gas discharge.

2. The apparatus according to claim 1, wherein said surface treatment means is disposed along a passage through which said substrates are conveyed by said conveying means.

3. The apparatus according to claim 1 or 2, wherein said discharge gas is gas containing at least oxygen.

4. The apparatus according to claim 1 or 2, wherein said processing or inspection means performs a plurality of different processes or inspections.

5. The apparatus according to claim 1 or 2, wherein said processing or inspection means comprises one or more of sputtering means, means for forming a resist film, wet etching means, and dry etching means.

6. A method of processing substrates, comprising the steps of:
processing or inspecting substrates;
conveying said substrates in order to perform said process or said inspection or after said process or said inspection has been performed; and
cleaning conveying means which conveys said substrates,
wherein said cleaning process is a process in which gas discharge is caused to take place in gas containing at least oxygen under the atmospheric pressure or a pressure near the atmospheric pressure, and at least portions of said conveying means, that are brought into direct contact with said substrates, are exposed to activation species/radicals of said gas generated due to the gas discharge.

7. The method according to claim 6, wherein said process for conveying said substrates consists of a plurality of conveying processes, and said cleaning process is a process in which said conveying means is washed between a first conveying process and a second conveying process.

8. An apparatus for processing substrates, comprising:
means for processing or inspecting substrates;
means for conveying said substrates toward said processing or inspecting means or from said processing or inspecting means; and
means for cleaning said conveying means,
wherein said cleaning means includes means for causing gas discharge to take place in gas containing at least oxygen under the atmospheric pressure or pressure near the atmospheric pressure, and as well as exposing at least portions of said conveying means, that are brought into direct contact with said substrates, to activation species/radicals of said gas generated due to the gas discharge.

9. The apparatus according to claim 8, wherein said cleaning means is disposed along a passage through which said substrates are conveyed by said conveying means.

10. The apparatus according to claim 8 or 9, wherein said processing or inspection means is means for performing a plurality of different processes or inspections.

11. An apparatus for processing substrates, comprising:
means for processing or inspecting substrates;
means for holding said substrates when said substrates are processed or inspected by said processing means or said inspection means; and
cleaning means for cleaning said holding means,
wherein said cleaning means causes gas discharge to take place in a predetermined discharge gas under the atmospheric pressure or pressure near the atmospheric pressure so as to expose said holding means to activation species/radicals of said discharge gas generated due to the gas discharge.

12. An apparatus for transferring substrates, comprising:
means for taking out substrates, one by one, from a first cassette that accommodates a plurality of substrates;
means for conveying said substrates taken out from said first cassette to a second cassette; and
means for accommodating said conveyed substrates into said second cassette,
wherein said conveying means has means for ashing said substrates that are being conveyed, and said ashing means consists of means for causing gas discharge to take place in a predetermined gas under the atmospheric pressure or pressure near the atmospheric pressure and means for exposing the surfaces of said substrates, that are being conveyed, to activation species/radicals of said gas generated due to said gas discharge.

13. The apparatus according to claim 12, wherein said gas discharge generating means has a grounded electrode having a size larger than that of said substrate and a dielectric member disposed between said grounded electrode and said substrate and having a size larger than that of said grounded electrode, said gas discharge generating means generating said gas discharge between said gas discharge generating means and said grounded electrode.

14. The apparatus according to claim 13, wherein said grounded electrode and said dielectric member can be moved integrally by said conveying means, and said substrate is conveyed while being placed on said dielectric member.

15. The apparatus according to claim 13, wherein said grounded electrode and said dielectric member are secured to predetermined positions, and said substrate is conveyed by said conveying means to pass through a position above said dielectric member.

16. The apparatus for transferring substrates according to claim 12, wherein said ashing means further includes means for supplying said predetermined gas to a position near said gas discharge generating means, and said exposing means is means for jetting out a gas flow containing activation species/radicals generated due to said gas discharge toward the surface of said substrate.
